# EUROPÄISCHE PATENTSCHRIFT

(11) **EP 0 766 175 B1**
(45) Veröffentlichungstag und Bekanntmachung des Hinweises auf die Patenterteilung: **17.07.2002**
(21) Anmeldenummer: 95112548.3
(22) Anmeldetag: 09.08.1995
(51) Int. Cl.: G06F 11/20

(54) **Integrierter Halbleiterspeicher mit Redundanzspeicherzellen**
Integrated semiconductor memory having redundant memory cells
Mémoire à semiconducteur intégrée avec cellules de mémoire redondantes

(43) Veröffentlichungstag der Anmeldung: 02.04.1997
(73) Patentinhaber: Infineon Technologies AG, 81669 München (DE)
(72) Erfinder: Rieger, Johann, 93199 Zell (DE)
(74) Vertreter: Kottmann, Heinz Dieter, Dipl.-Ing.

(56) Entgegenhaltungen:
- EP-A- 0 554 052
- WO-A-93/21578
- DE-A- 4 241 327
- US-A- 4 914 632

## Beschreibung

Die Erfindung bezieht sich auf einen integrierten Halbleiterspeicher mit Redundanzeinrichtung, mit Normalspeicherzellen, die matrixförmig an Kreuzungsstellen von Wortleitungen und Bitleitungen angeordnet sind, Wortleitungsdekoder zur Auswahl einer Wortleitung in Abhängigkeit von an den Halbleiterspeicher anlegbaren Wortleitungsadressignalen, Bitleitungsdekoder zur Auswahl einer Bitleitung in Abhängigkeit von an den Halbleiterspeicher anlegbaren Bitleitungsadressignalen, den Bitleitungen der Normalspeicherzellen zugeordnete Leseschaltungen, die ausgangsseitig mit Datenleitungen verbunden sind, an denen der aus den Normalspeicherzellen auszulesende Dateninhalt auszugeben ist, und mit Redundanzspeicherzellen, die vermittels zumindest eines programmierbaren Redundanzdekoders für den Ersatz einer defekten Speicherzelle adressierbar sind.

Bei modernen integrierten Halbleiterspeichern sind die Speicherzellen in mehreren Speicherfeldblockeinheiten angeordnet. Im Betrieb wird aus Gründen der Strom- und Zeitersparnis in Abhängigkeit von Adressignalen jeweils nur eine Speicherfeldblockeinheit aktiviert. Zur Erhöhung der Ausbeute bei der Herstellung dieser Halbleiterspeicher ist es bekannt, redundante Leitungen mit Redundanzspeicherzellen entlang der redundanten Leitungen vorzusehen. Die redundanten Leitungen werden beim Betrieb im Bedarfsfall, daß heißt, wenn redundante Speicherzellen defekte normale Speicherzellen ersetzen sollen ("Redundanzfall"), anstelle der normalen Leitungen angesteuert. Dies erfolgt über sogenannte Redundanzdekoder, die auf die Adresse der jeweiligen normalen Leitung mit den zu ersetzenden defekten Speicherzellen programmierbar sind.

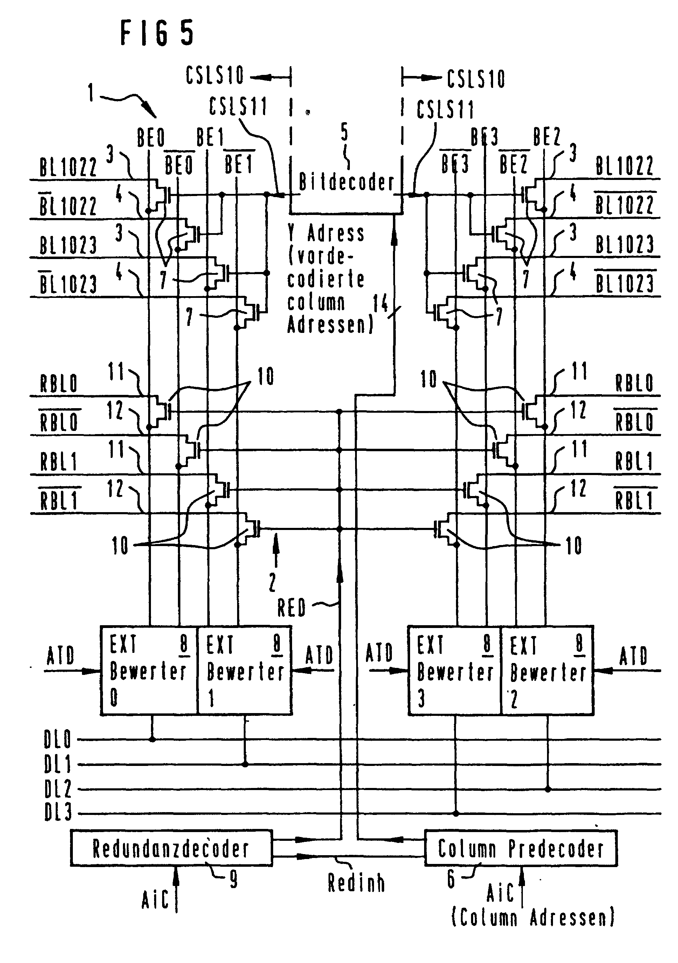

Fig. 5 zeigt in schematischer Darstellung einen bisher verwendeten integrierten Halbleiterspeicher 1 mit Redundanzeinrichtung 2. Der Speicher besitzt Normalspeicherzellen, die matrixförmig an Kreuzungsstellen von (hier nicht näher dargestellten) Wortleitungen und Bitleitungen 3, 4 angeordnet sind, wobei die Bitleitungen paarweise in an sich bekannter Weise in Bitleitungen 3 und komplementäre Bitleitungen 4 organisiert sind, und jede Bitleitung 3, 4 üblicherweise zwei Hälften enthält, von denen die eine in der Darstellung gemäß Fig. 5 auf der rechten Seite und die andere Hälfte auf der linken Seite angeordnet ist. Es sind (hier nicht näher dargestellte) Wortleitungsdekoder zur Auswahl einer Wortleitung in Abhängigkeit von an den Halbleiterspeicher anlegbaren Wortleitungsadressignalen, und Bitleitungsdekoder 5 zur Auswahl einer Bitleitung 3, 4 in Abhängigkeit von an den Halbleiterspeicher anlegbaren Bitleitungsadressignalen vorgesehen, wobei den Bitleitungsdekodern 5 in bekannter Weise Bitleitungsvorladungs-(Precharge)-einrichtungen 6 vorgeschaltet sind, vermittels derer die Bitleitungen 3, 4 vor dem Auslesen der Daten auf ein Prechargepotential aufgeladen werden. An dem einen Eingang der Bitleitungsvorladungseinrichtung 6 liegt ein Signal AIC (= Address Input Column) an, aus dem Spaltenadressignale zur Ansteuerung des Bitleitungsdekoders 5 abgeleitet werden. Am Ausgang des Bitleitungsdekoders 5 liegen Spaltenauswahlsignale CSLS (= Column Select Signals) an, die zur Aktivierung von Schaltern 7 in an sich bekannter Weise zur Auswahl der Bitleitungen 3, 4 zugeführt werden. Des weiteren sind den Bitleitungen 3, 4 der Normalspeicherzellen Leseschaltungen 8 (allgemein bekannte Leseverstärker) zugeordnet, die ausgangsseitig mit Datenleitungen DL0, DL1, DL2, DL3 verbunden sind, an denen der aus den Normalspeicherzellen auszulesende Dateninhalt auszugeben ist. Der Speicher besitzt ferner (nicht näher dargestellte) Redundanzspeicherzellen, die vermittels eines programmierbaren Redundanzdekoders 9 für den Ersatz einer defekten Speicherzelle adressierbar sind. Hierzu ist dem Redundanzdekoder 9 eine (nicht näher gezeigte) Programmierungseinrichtung zur Programmierung einer Spaltenadresse der Redundanzspeicherzellen zugeordnet, welche Programmierungseinrichtung an sich bekannte, durch Licht- oder Stromeinwirkung trennbare Fuse-Elemente besitzt. Der Redundanzdekoder 9, an dem eingangsseitig ebenfalls das Spaltenadressignal AIC anliegt, gibt zum einen ein Redundanzinhibit-Signal REDINH zur Steuerung der Bitleitungsvorladungseinrichtung 6, und zum anderen ein Redundanzauswahlsignal RED zur Ansteuerung von Schaltern 10 aus, die eine Verbindung der ausgewählten Redundanzbitleitungen 11 und hierzu komplementären Redundanzbitleitungen 12 mit den Leseschaltungen 8 ermöglichen, um im Redundanzfall den Dateninhalt der (nicht näher dargestellten) Redundanzspeicherzelle anstelle der normalen Speicherzelle an die Datenleitungen DL0 bis DL3 auszugeben.

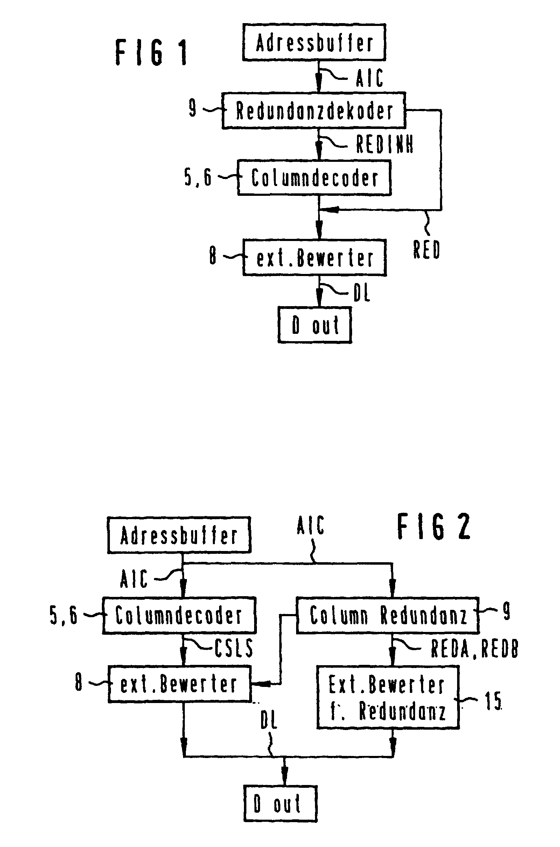

Anhand der schematischen Darstellung gemäß Fig. 1 soll im folgenden ein Nachteil bei der Wirkungsweise der bisher ver wendeten Redundanzeinrichtung gemäß Fig. 5 erläutert werden. Im Redundanzfall ist es erforderlich, daß die Decodierung der Normalbitleitungen 3, 4 gesperrt wird, damit vermittels der Sensorschaltungen 8 ein eindeutiges Redundanzbitleitungssignal ausgelesen werden kann. Da die Redundanzbitleitungen 11, 12 zusammen mit den Normalbitleitungen 3, 4 an denselben Leseschaltungen 8 verbunden sind, und aus diesem Grunde immer nur entweder Daten aus normalen Speicherzellen oder Daten aus Redundanzspeicherzellen ausgelesen werden können, muß der Bitleitungsdekoder 5 bzw. die Bitleitungsvorladungseinrichtung 6 durch den Redundanzdekoder 9 freigegeben werden.

Die bekannte Anordnung einer Redundanzeinrichtung besitzt darüber hinaus den Nachteil, daß in jeder einzelnen Speicherfeldblockeinheit nur maximal so viele Normalbitleitungen durch Redundanzbitleitungen ersetzbar sind, wie es der Anzahl der Redundanzbitleitungen einer solchen Speicherfeldblockeinheit entspricht. Jede Speicherfeldblockeinheit wird dabei verstanden als eine Einheit mit einer Anzahl von jeweils acht Arrays bzw. Speicherzellenblöcken von Speicherzellen, die in an sich bekannter Weise unabhängig voneinander aktivierbar und betreibbar sind. Im Betrieb werden bei einem solchen Halbleiterspeicher nicht sämtliche Einheiten gleichzeitig betrieben, sondern jeweils nur ein Teil der Speicherfeldblockeinheiten. Zu diesem Zweck ist jede Speicherfeldblockeinheit mittels eines der jeweiligen Speicherfeldblockeinheit zugeordneten Blockauswahlsignals auswählbar. Die Auswahl erfolgt mittels eines nicht näher dargestellten Blockdekoders, der durch einen ersten Teil der Wortleitungsadressignale (und der dazu komplementären Signale) gesteuert wird und sämtliche Speicherfeldblockeinheiten gleichzeitig aktiviert. Dies kann nun in der Praxis dazu führen, daß ein solcher Halbleiterspeicher in einer Speicherfeldblockeinheit mehr Normalbitleitungen mit defektbehafteten Speicherzellen enthält als in eben derselben Speicherfeldblockeinheit Redundanzbitleitungen mit entsprechenden Redundanzspeicherzellen vorhanden sind. Ein solcher Speicher ist dann mit Hilfe der bislang bekannten Redundanz-Architektur nicht reparierbar, obwohl in anderen Speicherblockeinheiten als der betrachteten Speicherfeldblockeinheiten eventuell noch genügend Redundanzbitleitungen mit Redundanzspeicherzellen vorhanden sind, die in diesen anderen Speicherfeldblockeinheiten nicht benutzt werden.

Der vorliegenden Erfindung liegt die Aufgabe zugrunde, einen integrierten Halbleiterspeicher mit einer Redundanzeinrichtung zur Verfügung zu stellen, welche im Bedarfsfall, daß heißt bei Vorliegen von defekten Speicherzellen, eine bessere Ausnutzung der Redundanzeinrichtung ermöglicht, und welche darüber hinaus einen minimalen Flächenbedarf, eine verringerte Belastung der Steuerleitungen, sowie einen schnelleren Zugriff auch auf die im Bedarfsfall einzusetzenden Redundanzspeicherzellen ermöglicht.

Diese Aufgabe wird durch einen integrierte Halbleiterspeicher gemäß Anspruch 1 gelöst.

Nächstliegender Stand der Technik ist Dokument US-A-4 914 632 (D1). Anspruch 1 wurde gegenüber den aus D1 bekannten Merkmalen abgegrenzt.

Der integrierte Halbleiter-Speicher gemäß der Erfindung zeichnet sich dadurch aus, daß den Redundanzspeicherzellen von dem zumindest einen programmierbaren Redundanzdekoder ansteuerbare externe Redundanzlese - bzw. Bewerterschaltungen zugeordnet sind, die eingangsseitig mit den Redundanzspeicherzellen und ausgangsseitig mit den Datenleitungen verbunden sind, und den von dem zumindest einen programmierbaren Redundanzdekoder ansteuerbaren externen Redundanzlese- bzw. Bewerterschaltungen jeweils eine Redundanzsteuerschaltung zugeordnet ist, welche zwischen der jeweils zugehörenden externen Redundanzlese- bzw. Bewerterschaltung und den Datenleitungen geschaltet ist und in Abhängigkeit eines von dem Redundanzdekoder ausgegebenen Redundanzauswahlsignales den am Ausgang einer externen Redundanzlese- bzw. Bewerterschaltung anliegenden Dateninhalt einer Redundanzspeicherzelle auf eine ausgewählte Datenleitung freigibt. Durch das Vorsehen von eigenen Leseschaltungen für die Redundanzspeicherzellen wird erreicht, daß der Bitleitungsdekoder nicht mehr vom Redundanzdekoder wie bei der bekannten Lösung freigegeben zu werden braucht, was in vorteilhafter Weise mit einer Adresslaufzeitverkürzung verbunden ist. Während im Gegensatz zum Stand der Technik, bei dem in der Regel die Redundanzdaten einer die defekte Speicherzelle zu ersetzenden Redundanzzelle erst nach Freigabe des normalen Spaltendekoders durch den Redundanzdekoder erfolgt, was mit einer zeitlichen Verzögerung des Zugriffes verbunden ist, ermöglicht es die erfindungsgemäße Anordnung der Redundanz-Schaltung, die Entscheidung, ob normale oder Redundanzdaten ausgegeben werden, erst beim eigentlichen Datenausgang zu treffen. Hierdurch ergibt sich eine erhebliche Verringerung der Zugriffszeit, etwa in der Größenordnung von etwa 2 ns (2 Nanosekunden). Darüber hinaus gestattet die erfindungsgemäße Anordnung eine flexible Zuordnung der Redundanzbitleitungen an verschiedene Datenleitungen, wodurch es insbesondere ermöglicht wird, daß Redundanzbitleitungen von gleichzeitig selektierten Speicherblökken untereinander verwendet werden können. Durch die erfindungsgemäße Redundanzanordnung wird trotz des schaltungstechnischen Mehraufwandes aufgrund der zusätzlich vorzusehenden Leseschaltungen für die Redundanzspeicherzellen eine bessere Ausnutzung der Redundanzspeicherzellen ermöglicht, da Speicherzellen aus anderen Speicherzellenblöcken- und -einheiten durch Redundanzspeicherzellen ersetzt werden können, so daß bei einer gleichbleibenden Zahl von Redundanzspeicherzellen im Vergleich zu den bekannten Redundanzanordnungen wesentlich mehr Redundanzspeicherzellen verwendet werden können.

In weiterer Ausgestaltung der Erfindung kann vorgesehen sein, daß die Redundanzspeicherzellen entlang von Redundanzbitleitung angeordnet sind und der programmierbare Redundanzdekoder ein eine Programmierungseinrichtung aufweisender Redundanzbitleitungsdekoder zur Auswahl einer Redundanzbitleitung der Redundanzspeicherzellen ist. Hierbei können die Redundanzbitleitungen paarweise in Redundanzbitleitungen und komplementären Redundanzbitleitungen angeordnet sein, wobei zumindest jedem Redundanzbitleitung-Paar eine eigene Redundanzleseschaltung zugeordnet sein kann.

Hierbei kann vorgesehen sein, daß den Redundanzbitleitungen Schalter zugeordnet sind, die von einem vom Redundanzdekoder ausgegebenen Redundanzauswahlsignals betätigt werden und die Verbindung der Redundanzbitleitungen mit den zugehörenden Redundanzleseschaltungen bewirken.

In weiterer Ausgestaltung der Erfindung kann vorgesehen sein, daß die Speicherzellen in einer Anzahl von Speicherfeldblockeinheiten organisiert sind, wobei jeder Speicherfeldblockeinheit eine Anzahl von Speicherzellenblöcken angeordnet sind. Im Betrieb werden nicht sämtliche Speicherfeldblockeinheiten gleichzeitig aktiviert und betrieben, sondern jeweils nur eine Speicherfeldblockeinheit. Hierzu ist jede Speicherfeldblockeinheit mittels eines der jeweiligen Speicherfeldblockeinheit zugeordneten Blockauswahlsignals auswählbar. Die erfindungsgemäße Anordnung der Redundanzeinrichtung ermöglicht es nun in vorteilhafter Weise, daß die Redundanzspeicherzellen innerhalb einer Speicherfeldblockeinheit für den Ersatz von defekten Speicherzellen aus zumindest zwei unterschiedlichen Speicherfeldblöcken innerhalb einer Einheit aktivierbar sind. Auf diese Weise wird eine im Vergleich zur vorbekannten Lösung, bei der immer nur Redundanzspeicherzellen aus einem bestimmten Speicherfeldblock aktivierbar sind, erheblich bessere Ausnutzung der Redundanzspeicherzellen ermöglicht.

Nachstehend wird ein Ausführungsbeispiel der Erfindung anhand der Zeichnung näher beschrieben. Es zeigt:
Figur 1 eine schematische Darstellung der zeitlichen Abfolge der Redundanzmaßnahmen bei einem bisher verwendeten Halbleiterspeicher;
Figur 2 eine schematische Darstellung der zeitlichen Abfolge der Redundanzmaßnahmen gemäß der Erfindung;
Figur 3 eine schematische Darstellung eines Halbleiterspeichers mit Redundanzeinrichtung gemäß einem Ausführungsbeispiel der Erfindung;
Figur 4 den erfindungsgemäßen Halbleiterspeicher mit Redundanzeinrichtung in weiteren Einzelheiten; und
Figur 5 einen bisher verwendeten Halbleiterspeicher mit Redundanzeinrichtung.

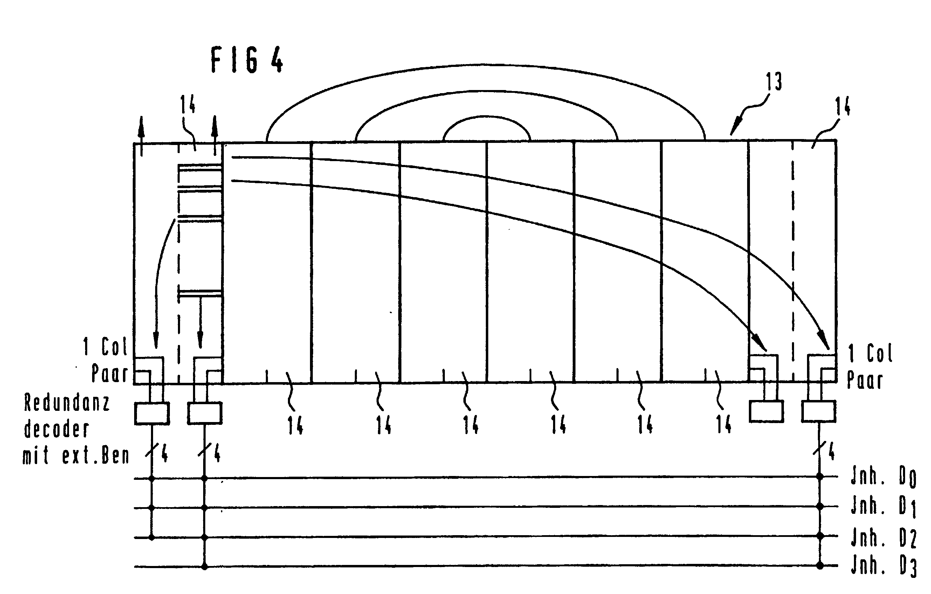

Die Zeichnung zeigt in schematischer Darstellung eine bevorzugte Ausführungsform des erfindungsgemäßen Halbleiterspeichers mit einer auf einem Halbleitersubstrat ausgebildeten Redundanzeinrichtung 2 für den Ersatz einer defekten Speicherzelle durch eine ebenfalls auf dem Halbleitersubstrat angeordneten Redundanzspeicherzelle. Soweit von aktivierten Signalen bzw. Signalen im aktivierten Zustand gesprochen wird, sollen diese Signale den Zustand "Log. 1" aufweisen, ansonsten den Zustand "Log. 0". Dies entspricht der sogenannten positiven Logik und dient lediglich einer einfacheren Darstellungsweise. Andere Logikvereinbarungen sind selbstverständlich möglich. Der dargestellte Halbleiterspeicher stellt einen 16 M dynamischen Halbleiterspeicher mit wahlfreiem Zugriff ("DRAM") dar, und besitzt eine Anzahl von beispielsweise vier Speicherfeldblockeinheiten mit darin enthaltenen Speicherzellen. Die Speicherfeldblockeinheiten sind schaltungstechnisch gleich aufgebaut, wobei eine Speicherfeldblokkeinheit 13 in Fig. 4 näher dargestellt ist. Jede Speicherfeldblockeinheit 13 wird dabei verstanden als eine Einheit mit einer Anzahl von jeweils acht Arrays bzw. Speicherzellenblöcken 14 von Speicherzellen, die in an sich bekannter Weise unabhängig voneinander aktivierbar und betreibbar sind. Die in den Blöcken 14 in jeweils einer Anzahl von 512 k angeordneten Speicherzellen werden begrifflich als normale Speicherzellen bezeichnet, deren Adressierung und Betrieb ohne Zuhilfenahme von irgendwelchen Redundanzschaltungsmitteln in bekannter Weise erfolgen kann. Die normalen Speicherzellen sind angeordnet entlang und somit adressierbar über (in der Figur nicht näher dargestellten) normalen Wortleitungen, sowie entlang von normalen Bitleitungen 3, 4, wobei jede normale Bitleitung üblicherweise zwei Hälften enthält. An die normalen Bitleitungen 3, 4 sind über Schalter 7 die Leseschaltungen 8 (Leseverstärker) angeschlossen. Die Speicherzellen sind hierbei über die jeweils zugehörigen normalen Bitleitungen und normalen Wortleitungen adressierbar mittels an den Halbleiterspeicher anlegbaren Adressignalen, typischerweise im allgemein bekannten Adressmultiplexverfahren. Dabei werden in an sich bekannter Weise zu einem ersten Zeitpunkt die für die Wortleitungsadressierung zuständigen Wortleitungsadressignale, gesteuert durch ein Taktsignal /RAS, in einem Wortleitungsadresspuffer zwischengespeichert. Entsprechend werden zu einem zweiten Zeitpunkt die für die Bitleitungsadressierung zuständigen Bitleitungsadressignale, gesteuert durch ein Taktsignal /CAS, in einem Bitleitungsadresspuffer zwischengespeichert. An den Ausgängen der Adresspuffer erscheinen diese Adressignale in True- und Komplementform. Im Betrieb werden bei einem solchen Halbleiterspeicher nicht sämtliche Speicherfeldblockeinheiten gleichzeitig aktiviert und betrieben, sondern jeweils nur eine Speicherfeldblockeinheit. Zu diesem Zweck ist jede Speicherfeldblockeinheit mittels eines der jeweiligen Speicherfeldblockeinheit zugeordneten Blockauswahlsignals auswählbar. Die Auswahl erfolgt mittels eines nicht näher dargestellten Blockdekoders, der durch einen ersten Teil der Wortleitungsadressignale (und der dazu komplementären Signale) gesteuert wird.

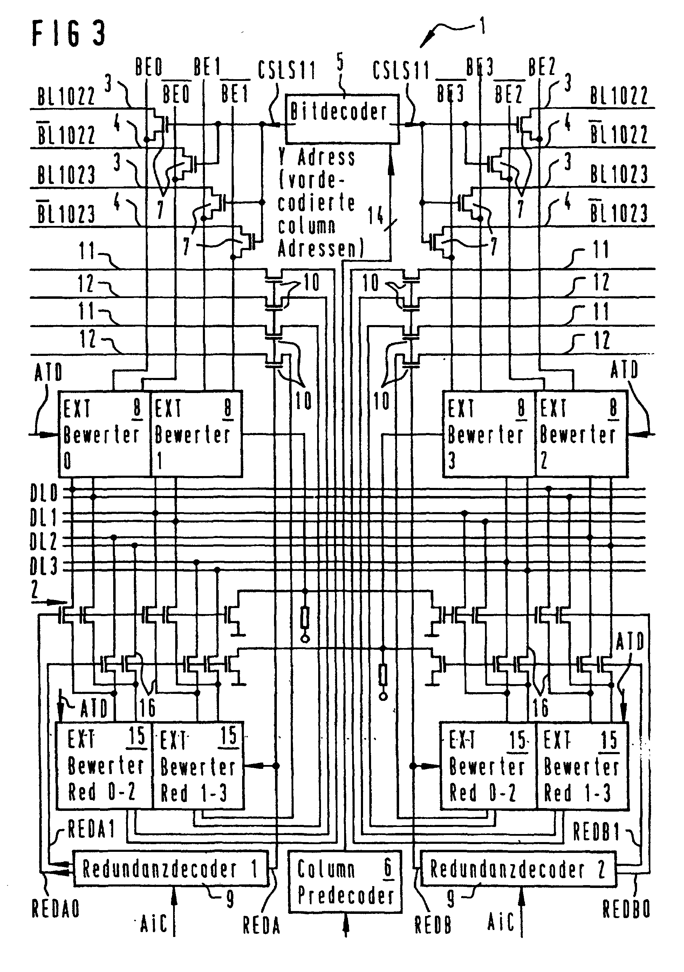

Erfindungsgemäß-ist vorgesehen, daß den Redundanzspeicherzellen von dem programmierbaren Redundanzdekoder 9 ansteuerbare, eigene Redundanzleseschaltungen 15 zugeordnet sind, die eingangsseitig mit den Redundanzspeicherzellen und ausgangsseitig mit den Datenleitungen DL0 bis DL3 verbunden sind. Hierbei sind die Redundanzbitleitungen 11, 12 paarweise in Redundanzbitleitungen 11 und komplementären Redundanzbitleitungen 12 angeordnet und es ist zumindest jedem Redundanzleitungspaar eine eigene Redundanzleseschaltung 15 zugeordnet. Ähnlich wie die den Normalspeicherzellen zugeordneten Leseschaltungen 8 stellen auch die Redundanzleseschaltungen 15 Bestandteile des an sich bekannten Leseverstärkers dar, welche in den Figuren auch als externe Bewerter bezeichnet sind. Wie insbesondere aus Fig. 3 ersichtlich ist, sind den Redundanzleseschaltungen 15 des weiteren Redundanzsteuerschaltungen 16 zugeordnet, die zwischen der jeweils zugehörenden Redundanzleseschaltung 15 und den Datenleitungen DL0 bis DL3 geschaltet sind und in Abhängigkeit eines von dem Redundanzdekoder 9 ausgegebenen Redundanzauswahlsignales REDA1, REDA0 den am Ausgang einer Redundanzleseschaltung 15 anliegenden Dateninhalt einer Redundanzspeicherzelle auf eine ausgewählte Datenleitung freigeben. Ein weiteres Redundanzauswahlsignal REDA steuert die Schalter 10 für die selektive Verbindung der Redundanzbitleitungen 11, 12 an die zugehörenden Redundanzleseschaltungen 15, und liegt gleichzeitig an den Redundanzleseschaltungen 15 zur Aktivierung derselben an. Das ebenfalls an den Redundanzleseschaltungen 15 anliegende Signal ATD bezeichnet ein Adress-Transient-Data-Signal.

Die Wirkungsweise der erfindungsgemäßen Redundanzeinrichtung gemäß Fig. 3 und Fig. 4 wird anhand der schematischen Darstellung gemäß Fig. 2 näher erläutert. Die vom Adressbuffer ausgegebenen Adressignale AIC bzw. hieraus abgeleitete Signale liegen gleichzeitig am normalen Spaltendekoder 5 und am Redundanzdekoder 9 an. Die an den normalen Bitleitungen 3, 4 anstehenden Dateninhalte der Normalspeicherzellen werden in üblicher Weise von den Leseschaltungen 8 ausgelesen. Gleichzeitig werden auch die im Redundanzfall vorliegenden Dateninhalte aus den Redundanzspeicherzellen durch die Redundanzleseschaltungen 15 ausgelesen. Falls nun ein Dateninhalt aus einer normalen Speicherzelle durch den Dateninhalt einer Redundanzspeicherzelle ersetzt werden soll,' werden die (normalen) Leseschaltungen 8 gesperrt, und die Redundanzleseschaltungen 15 entsprechend auf die Datenleitungen DL0 bis DL3 freigegeben. Dies erfolgt in Abhängigkeit von den gemäß dem Zustand der Programmierungseinrichtung fest programmierten Redundanzauswahlsignale REDA, REDB, die der Redundanzdekoder 9 an die Schalter und die Redundanzsteuerschaltung 16 ausgibt.

Die Redundanzspeicherzellen sind verwendbar, um mit Fehler behaftete normale Speicherzellen zu ersetzen, wobei der Fehler sowohl in den zu ersetzenden Speicherzellen selbst oder im Zusammenhang mit deren Betrieb auftreten kann, beispielsweise Fehler bei den zugeordneten Bitleitungen, Wortleitungen, Leseverstärkern, Adressdekodern.

Während bei der bisherigen Lösung gemäß Fig. 1 der normale Columndekoder in jedem Fall vom Redundanzdekoder freigegeben werden muß, wird bei der erfindungsgemäßen Lösung gemäß Fig. 2 die Entscheidung, ob normale oder Redundanzdaten ausgegeben werden, erst beim eigentlichen Datenausgang getroffen, so daß ein Geschwindigkeitsvorteil von etwa 2 ns ermöglicht wird.

## Patentansprüche

1. Integrierter Halbleiterspeicher mit Redundanzeinrichtung, der folgende Merkmale aufweist:
- Normalspeicherzellen, die matrixförmig an Kreuzungsstellen von Wortleitungen und Bitleitungen (3, 4) angeordnet sind,
- Wortleitungsdekoder zur Auswahl einer Wortleitung in Abhängigkeit von an den Halbleiterspeicher (1) anlegbaren Wortleitungsadressignalen,
- Bitleitungsdekoder (5) zur Auswahl einer Bitleitung (3, 4) in Abhängigkeit von an den Halbleiterspeicher (1) anlegbaren Bitleitungsadressignalen,
- den Bitleitungen (3, 4) der Normalspeicherzellen zugeordnete externe Lese- bzw. Bewerterschaltungen (8), die ausgangsseitig mit Datenleitungen (DL0 bis DL3) verbunden sind, an denen der aus den Normalspeicherzellen auszulesende Dateninhalt auszugeben ist, und
- Redundanzspeicherzellen, die vermittels zumindest eines programmierbaren Redundanzdekoders (9) für den Ersatz einer defekten Speicherzelle adressierbar sind,
**dadurch gekennzeichnet, daß**
den Redundanzspeicherzellen von dem zumindest einen programmierbaren Redundanzdekoder (9) ansteuerbare externe Redundanzlese- bzw. Bewerterschaltungen (15) zugeordnet sind, die eingangsseitig mit den Redundanzspeicherzellen und ausgangsseitig mit den Datenleitungen (DL0 bis DL3) verbindbar sind, und den von dem zumindest einen programmierbaren Redundanzdekoder (9) ansteuerbaren externen Redundanzlese- bzw. Bewerterschaltungen (15) jeweils eine Redundanzsteuerschaltung (16) zugeordnet ist, welche zwischen der jeweils zugehörenden externen Redundanzlese- bzw. Bewerterschaltung (15) und den Datenleitungen (DL0 bis DL3) geschaltet ist und in Abhängigkeit eines von dem Redundanzdekoder (9) ausgegebenen Redundanzauswahlsignales (REDA, REDB) den am Ausgang einer externen Redundanzlese- bzw. Bewerterschaltung (15) anliegenden Dateninhalt einer Redundanzspeicherzelle auf eine ausgewählte Datenleitung (DL0 bis DL3) freigibt.

2. Integrierter Halbleiterspeicher nach Anspruch 1, **dadurch gekennzeichnet, daß** die Redundanzspeicherzellen entlang von Redundanzbitleitungen (11, 12) angeordnet sind und der programmierbare Redundanzdekoder (9) ein eine Programmierungseinrichtung aufweisender Redundanzbitleitungsdekoder zur Auswahl einer Redundanzbitleitung (11, 12) der Redundanzspeicherzellen ist.

3. Integrierter Halbleiterspeicher nach Anspruch 1 oder 2, **dadurch gekennzeichnet, daß** die Redundanzbitleitungen (11, 12) paarweise in Redundanzbitleitungen (11) und komplementären Redundanzbitleitungen (12) angeordnet sind und zumindest jedem Redundanzbitleitungs-Paar (11, 12) eine eigene externe Redundanzlese- bzw. Bewerterschaltung (15) zugeordnet ist.

4. Integrierter Halbleiterspeicher nach Anspruch 1 bis 3, **dadurch gekennzeichnet, daß** den Redundanzbitleitungen Schalter (10) zugeordnet sind, die von einem vom Redundanzdekoder (9) ausgegebenen Redundanzauswahlsignals betätigt werden und die Verbindung der Redundanzbitleitungen mit den zugehörenden externen Redundanzlese- bzw. Bewerterschaltungen bewirken.

5. Integrierter Halbleiterspeicher nach Anspruch 1 bis 4, **dadurch gekennzeichnet, daß** die Normalspeicherzellen in mehreren, über zugehörige Aktivierungseinrichtungen einzeln aktivierbaren Speicherfeldblockeinheiten (13) angeordnet sind, welche aktivierbaren Speicherfeldblockeinheiten (13) über ihre Aktivierungseinrichtungen vermittels Blockauswahlsignalen aktivierbar sind.

6. Integrierter Halbleiterspeicher nach Anspruch 1 bis 5, **dadurch gekennzeichnet, daß** die Redundanzspeicherzellen innerhalb einer Speicherfeldblockeinheit für den Ersatz von defekten Speicherzellen aus zumindest zwei unterschiedlichen Speicherfeldblöcken (14) aktivierbar sind.

7. Integrierter Halbleiterspeicher nach Anspruch 1 bis 6, **dadurch gekennzeichnet, daß** die Programmierbarkeit des Redundanzdekoders durch eine Programmierungseinrichtung programmierbares Element gegeben ist, welche durch Licht- oder Stromeinwirkung trennbare Fuse-Elemente besitzt.

8. Integrierter Halbleiterspeicher nach Anspruch 1 bis 7, **dadurch gekennzeichnet, daß** der Halbleiterspeicher (1) einen dynamischen Halbleiterspeicher mit wahlfreiem Zugriff (DRAM) darstellt.

9. Integrierter Halbleiterspeicher nach Anspruch 8, **dadurch gekennzeichnet, daß** der dynamische Halbleiterspeicher mit wahlfreiem Zugriff eine Speicherzellenanzahl von 4 Mega, 16 Mega oder mehr besitzt.

## Claims

1. Integrated semiconductor memory having a redundancy device, which has the following features:
- normal memory cells arranged in matrix form at crossover points of word lines and bit lines (3, 4),
- word line decoders for the selection of a word line in a manner dependent on word line address signals which can be applied to the semiconductor memory (1),
- bit line decoders (5) for the selection of a bit line (3, 4) in a manner dependent on bit line address signals which can be applied to the semiconductor memory (1),
- external sense or evaluation circuits (8) which are assigned to the bit lines (3, 4) of the normal memory cells and, on the output side, are connected to data lines (DL0 to DL3) on which the data content that is to be read from the normal memory cells is to be output, and
- redundancy memory cells which can be addressed by means of at least one programmable redundancy decoder (9) for the replacement of a defective memory cell,
**characterized in that**
the redundancy memory cells are assigned external redundancy sense or evaluation circuits (15) which can be driven by the at least one programmable redundancy decoder (9) and can be connected to the redundancy memory cells on the input side and to the data lines (DL0 to DL3) on the output side, and the external redundancy sense or evaluation circuits (15) which can be driven by the at least one programmable redundancy decoder (9) are each assigned a redundancy control circuit (16) which is connected between the respectively associated external redundancy sense or evaluation circuit (15) and the data lines (DL0 to DL3) and, depending on a redundancy selection signal (REDA, REDB) output by the redundancy decoder (9), enables the data content - present at the output of an external redundancy sense or evaluation circuit (15) - of a redundancy memory cell onto a selected data line (DL0 to DL3).

2. Integrated semiconductor memory according to Claim 1, **characterized in that** the redundancy memory cells are arranged along redundancy bit lines (11, 12) and the programmable redundancy decoder (9) is a redundancy bit line decoder having a programming device and serving for the selection of a redundancy bit line (11, 12) of the redundancy memory cells.

3. Integrated semiconductor memory according to Claim 1 or 2, **characterized in that** the redundancy bit lines (11, 12) are arranged in pairs in redundancy bit lines (11) and complementary redundancy bit lines (12) and at least each redundancy bit line pair (11, 12) is assigned a dedicated external redundancy sense or evaluation circuit (15).

4. Integrated semiconductor memory according to Claims 1 to 3, **characterized in that** the redundancy bit lines are assigned switches (10) which are actuated by a redundancy selection signal output by the redundancy decoder (9) and effect the connection of the redundancy bit lines to the associated external redundancy sense or evaluation circuits.

5. Integrated semiconductor memory according to Claims 1 to 4, **characterized in that** the normal memory cells are arranged in a plurality of memory array block units (13) which can be activated individually by means of associated activation devices, which activatable memory array block units (13) can be activated by means of their activation devices by means of block selection signals.

6. Integrated semiconductor memory according to Claims 1 to 5, **characterized in that** it is possible to activate the redundancy memory cells within a memory array block unit for the replacement of defective memory cells from at least two different memory array blocks (14).

7. Integrated semiconductor memory according to Claims 1 to 6, **characterized in that** the programmability of the redundancy decoder is provided [lacuna] element which can be programmed by a programming device, which has fuse elements which can be separated by the action of light or current.

8. Integrated semiconductor memory according to Claims 1 to 7, **characterized in that** the semiconductor memory (1) constitutes a dynamic random access semiconductor memory (DRAM).

9. Integrated semiconductor memory according to Claim 8, **characterized in that** the dynamic random access semiconductor memory has a number of memory cells of 4 mega, 16 mega or more.

## Revendications

1. Mémoire à semiconducteur intégrée à dispositif de redondance qui comporte les caractéristiques suivantes :
- des cellules de mémoire normales qui sont disposées en forme de matrice aux points d'intersection de lignes de mots et de lignes de bits (3, 4),
- des décodeurs de lignes de mots, destinés à sélectionner une ligne de mots en fonction de signaux d'adresse de lignes de mots qui peuvent être appliqués à la mémoire (1) à semiconducteur,
- des décodeurs (5) de lignes de bits, destinés à sélectionner une ligne (3, 4) de bits en fonction de signaux d'adresse de lignes de bits qui peuvent être appliqués à la mémoire (1) à semiconducteur,
- des circuits (8) extérieurs de lecture ou d'évaluation, associés aux lignes (3, 4) de bits des cellules de mémoire normales et reliés du côté de la sortie à des lignes (DL0 à DL3) de données, sur lesquelles le contenu de données que l'on peut lire dans les cellules de mémoire normales est sorti, et
- des cellules de mémoire redondantes, qui peuvent être adressées au moyen d'au moins un décodeur (9) programmable de redondance, pour le remplacement d'une cellule de mémoire défectueuse,
**caractérisée en ce que**,
aux cellules de mémoire redondantes sont associées, par le au moins un décodeur (9) programmable de redondance, des circuits (15) extérieurs de redondance de lecture ou d'évaluation, qui peuvent être commandés et qui peuvent être reliés du côté de l'entrée aux cellules de mémoire redondantes et du côté de la sortie aux lignes (DL0 à DL3) de données, et aux circuits extérieurs de lecture ou d'évaluation de redondance, qui peuvent être commandés par le au moins un décodeur (9) programmable de redondance, est associé respectivement un circuit (16) de commande de redondance, qui est monté entre le circuit (15) extérieur de lecture ou d'évaluation de redondance associé correspondant et les lignes (DL0 à DL3) de données et qui, en fonction d'un signal (REDA, REDB) de sélection de redondance émis par le décodeur de redondance, libère sur une ligne (DL0 à DL3) de données sélectionnée, le contenu de données d'une cellule de mémoire redondante s'appliquant à la sortie d'un circuit (15) extérieur de lecture ou d'évaluation de redondance.

2. Mémoire à semiconducteur intégrée suivant la revendication 1, **caractérisée en ce que** les cellules de mémoire redondantes sont disposées le long de lignes (11, 12) de bits de redondance, et le décodeur (9) programmable de redondance est un décodeur de lignes de bits de redondance comportant un dispositif de programmation et destiné à sélectionner une ligne (11, 12) de bits de redondance des cellules de mémoire redondantes.

3. Mémoire à semiconducteur intégrée suivant la revendication 1 ou 2, **caractérisée en ce que** les lignes (11, 12) de bits de redondance sont disposées par paire dans des lignes (11) de bits de redondance et dans des lignes (12) de bits de redondance complémentaires, et il est associé au moins à chaque paire (11, 12) de lignes de bits de redondance, un circuit (15) extérieur de lecture ou d'évaluation de redondance.

4. Mémoire à semiconducteur intégrée suivant la revendication 1 à 3, **caractérisée en ce qu'**il est associé aux lignes de bits de redondance des commutateurs (10), qui sont actionnés par un signal de sélection de redondance émis par le décodeur (9) de redondance, et qui provoquent la liaison des lignes de bits de redondance avec les circuits extérieurs correspondants de lecture ou d'évaluation de redondance.

5. Mémoire à semiconducteur intégrée suivant la revendication 1 à 4, **caractérisée en ce que** les cellules de mémoire normales sont disposées en plusieurs unités (13) de blocs de champ de mémoire pouvant être activées individuellement par des dispositifs d'activation associés, les unités (13) de blocs de champs de mémoire, qui peuvent être activées, pouvant être activées par leur dispositif d'activation au moyen de signaux de sélection de bloc.

6. Mémoire à semiconducteur intégrée suivant la revendication 1 à 5, **caractérisée en ce que** les cellules de mémoire de redondance au sein d'une unité de blocs de champ de mémoire peuvent être activées pour le remplacement de cellules de mémoire défectueuses, dans au moins deux blocs (14) de champ de mémoire différents.

7. Mémoire à semiconducteur intégrée suivant la revendication 1 à 6, **caractérisée en ce que** la possibilité de programmer le décodeur de résonance par un dispositif de programmation, est donnée par un élément programmable qui a des éléments de fuse, qui peuvent être séparés par l'action de la lumière ou par l'action du courant.

8. Mémoire à semiconducteur intégrée suivant la revendication 1 à 7, **caractérisée en ce que** la mémoire (7) à semiconducteur constitue une mémoire à semiconducteur dynamique à accès libre (DRAM).

9. Mémoire à semiconducteur intégrée suivant la revendication 8, **caractérisée en ce que** la mémoire à semiconducteur dynamique a accès libre à un nombre de cellules de mémoire de 4 Méga, de 16 Méga ou plus.
